# EUROPEAN PATENT SPECIFICATION

(11) **EP 4 682 494 B1**
(45) Date of publication and mention of the grant of the patent: **14.10.2026**
(21) Application number: 24306202.3
(22) Date of filing: 17.07.2024
(51) Int. Cl.: G01K 7/01, G01K 7/16, H03K 17/08

(54) **DEVICE FOR ESTIMATING JUNCTION TEMPERATURE OF A POWER SEMICONDUCTOR AND ASSOCIATED METHOD FOR MONITORING SUCH JUNCTION TEMPERATURE**
VORRICHTUNG ZUR ERFASSUNG DER SPERRSCHICHTTEMPERATUR EINES LEISTUNGSHALBLEITERS UND ZUGEHÖRIGES VERFAHREN ZUM ÜBERWACHEN EINER SOLCHEN SPERRSCHICHTTEMPERATUR
DISPOSITIF D'ESTIMATION DE LA TEMPERATURE DE JONCTION D'UN SEMI-CONDUCTEUR DE PUISSANCE ET PROCEDE ASSOCIE DE SURVEILLANCE DE CETTE TEMPERATURE DE JONCTION

(43) Date of publication of application: 21.01.2026
(73) Proprietor: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: QUEMENER, Vincent, 35708 RENNES CEDEX 7 (FR); DEGRENNE, Nicolas, 35708 RENNES CEDEX 7 (FR)
(74) Representative: Plasseraud IP

(56) References cited:
- US-A1- 2023 088 396
- NIU HE ET AL: "Sensing Gallium Nitride HEMT junction temperature using gate drive output transient properties", 2016 IEEE APPLIED POWER ELECTRONICS CONFERENCE AND EXPOSITION (APEC), IEEE, 20 March 2016 (2016-03-20), pages 2055 - 2062, XP032899062, ISBN: 978-1-4673-8393-6, [retrieved on 20160510], DOI: 10.1109/APEC.2016.7468150

## Description

### Technical Field

This disclosure pertains to the field of monitoring of the health of electronic power semiconductors or power semiconductor modules such as solid-state switching modules and concerns a device for estimating junction temperature of a power semiconductor and associated method for monitoring such junction temperature.

### Background Art

The on-line estimation of the temperature of the power semi-conductor device such as IGBT or MOSFET is required for over-temperature detection and protection and for monitoring the state of the health of the power module. Different solution exists to detect/measure the junction temperature in the prior art.

A first prior art method uses a device-embedded sense diode with a reproducible, linear, and high (negative) sensitivity of its threshold voltage with temperature. A relatively simple external circuit is used to detect an under-value or measure the threshold voltage. However, the implementation of the diode on the chip results in a loss of active area of the transistor and increases the number of connections.

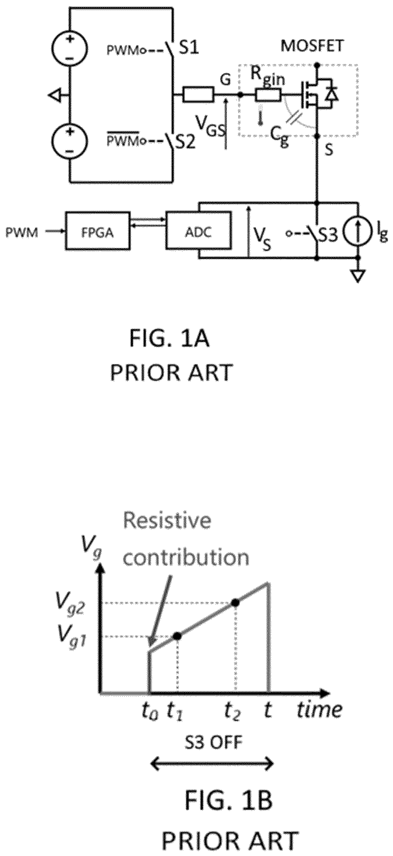

A second prior art method for a MOSFET power semiconductor according to figures 1A uses the internal gate resistor R_{gin} as a temperature sensitive electric parameter (TSEP). The junction temperature is estimated from the gate temperature. A sense current Ig is injected through the gate during the PWM. The voltage response V_{S} is temperature sensitive. The injection time is driven by a switch S3 which is OFF to inject the current.

For over-temperature detection, the voltage response is compared with the voltage response with an emulated gate circuit which values are defined to correspond to one or several temperature thresholds.

Since the internal gate resistance value may vary from a power module reference to another, an individual calibration is required which may be complex and costly to implement.

For temperature measurement, the voltage response is sampled with an analog to digital converter (ADC). The calibration can be software-based.

In addition, as shown in figure 1B, during the current injection, the voltage V_{GS} after a starting value dependent of R_{gin} increases due to the internal capacitor C_{g} of the MOSFET. Due to such increase, the measurement must be done quickly after opening of the switch S3 and requires a fast analog to digital converter.

In consequence, this method such as disclosed in European patent application EP24305034.1 filed January 8, 2024, requires a good synchronization between the current injection and the measurement with a complex and costly circuit which can limit it use in industrial application.

In addition, this requires a high-resolution and fast ADC to precisely monitor samples in a sufficiently short time to not influence the gate voltage and not compromise it normal operation. This can be a limitation for low-cost systems since the resolution and sampling speed of the ADC directly relate to the quality of the temperature estimation.

As a result, the methods based on the internal gate resistance are precise and accurate. Their main limitation is related to individual calibration and complexity and cost of implementation. Furthermore, it would be easier for the industrial actors to adopt a technique which provides an analog voltage value sensitive to the temperature, such as the one that can be generated with the built-in diodes. This analog value could then be used for either over-temperature detection or temperature estimation, eventually in another circuit board. US2023088396A1 discloses an apparatus and a method for determining a transistor junction temperature by monitoring the gate-emitter voltage during the ON-state of a PWM modulation cycle.

### Summary

In view of such prior art, the problem addressed by the invention is to provide an analogue signal linearly dependent of a temperature of a power semi-conductor die, in order to determine the temperature of such power semiconductor die in a simple and low-cost manner with low calibration effort. In this regard, the present disclosure concerns a device for measuring a junction temperature of a power semiconductor using the resistance Rgint of said semiconductor comprising at least:
- a current injector circuit injecting current pulses Iᵢₙⱼ in the gate path of said power semiconductor through the emitter of said power semiconductor, said current injector circuit being driven by a digital injection control circuit to synchronize said current pulses within a stabilized part of ON states of the power semiconductor driver PWM signal driving said power semiconductor ,
- a peak detector circuit to record emitter voltage peaks Vₑ at the terminals of the current injector circuit and generate a continuous signal Vₚₖₛ dependent of the junction temperature Tj through integration of said voltage peaks,
- a signal conditioning circuit to adapt the continuous signal Vₚₖₛ dependent of the junction temperature into a range of 3V to 5V of a measurement system.

In realization modes which may be combined or alternatives:
Said current pulses injected in said gate path may have durations calculated to limit contribution of the power semiconductor gate capacitor C_{g} value to the emitter voltage peaks.
Said current pulses injected in said gate path have a typical duration of 20 ns to 200 ns.

The injection of said current pulses may start between 20% and 50 % of the ON state of the power semiconductor.

The current injector circuit may be a current source and wherein the current pulses Iᵢₙⱼ have a typical amplitude of 20 mA to 200 mA.

The digital injection control circuit may comprise a switch SW1 shorting said current source when said current pulses are not injected.

The device may comprise a gate resistor on the bypass switch 6.

Said gate resistor value may be chosen between 1 Ohm and 100 Ohm.

The current pulse Iᵢₙⱼ may be synchronized through the Vge gate signal generated by the gate driver.

The current pulse Iᵢₙⱼ may be started between 1µs and 10µs after a turn-ON order of the power semiconductor from the driver to be injected in a stable on period of the power semiconductor.

The present disclosure concerns also a converter comprising at least one power module equipped with at least one power semiconductor and equipped with a device according to the present disclosure.

The present disclosure concerns also a method for measuring a junction temperature of a power semiconductor through the measurement of the gate resistance of such power semiconductor comprising injecting current pulses Iᵢₙⱼ in the gate path of said power semiconductor through the emitter of said power semiconductor, said current pulses being synchronized with a stabilized part of ON states of the power semiconductor and detecting emitter voltage peaks Vₑ at terminals of a current generator circuit injecting said current pulses and integrating said peaks Vₑ to generate a continuous signal Vₚₖₛ dependent of the junction temperature Tj,

The method may comprise providing said current pulses Iᵢₙⱼ through unshorting a current generator connected between the gate driver ground G and an emitter of said power semiconductor for the duration of said current pulses Iᵢₙⱼ.

The continuous signal Vₚₖₛ dependent of the junction temperature may be adapted to correspond to a range of 3V to 5V of a measurement system.

Said signal Vₚₖₛ may be converted into a temperature θj in said measurement system and said temperature θj is displayed and/or compared to a maximum acceptable temperature θjmax to provide a warning when said temperature θj is above said maximum acceptable temperature θjmax.

In other aspects, it is proposed a computer software comprising instructions to implement at least a part of a method as defined hereabove when the software is executed by a processor and it is proposed a computer-readable non-transient recording medium on which a software is registered to implement the method as defined hereabove when the software is executed by a processor.

### Brief Description of Drawings

Other features, details and advantages will be shown in the following detailed description and on the figures, on which:
Figure 1A discloses a prior art R_{gint} measurement device for semiconductor temperature measurement;
Figure 1B shows the variation of the V_{GS} voltage during injection;
Figure 2 discloses a schematic representation of a R_{gint} measurement circuit of the present disclosure;
Figure 3 discloses curves showing a temperature measurement based on the measurement circuit of figure 2;
Figures 4A and 4B show emitter voltage versus time curve depending on a pulse duration;
Figure 4C shows a representation of Vₑ versus time and the corresponding ΔR_{gint} variation versus tᵢₙⱼ caused by a semiconductor gate-emitter capacitor;
Figure 5 shows an example of implementation of a digital injection control circuit as in figure 1;
Figure 6 shows an example of implementation of a peak detector as in figure 1;
Figure 7 shows a schematic representation of the circuit of figure 1 with an additional over-temperature detection circuit;
Figure 8 shows a simplified flowchart of a method of the present disclosure;
Figure 9 shows an alternative mode of implementation of a R_{gint} measurement circuit of the present disclosure.

### Description of Embodiments

The present disclosure concerns a method and device using the internal gate resistance of a power semiconductor as a temperature sensitive parameter to measure the junction temperature of said semiconductor.

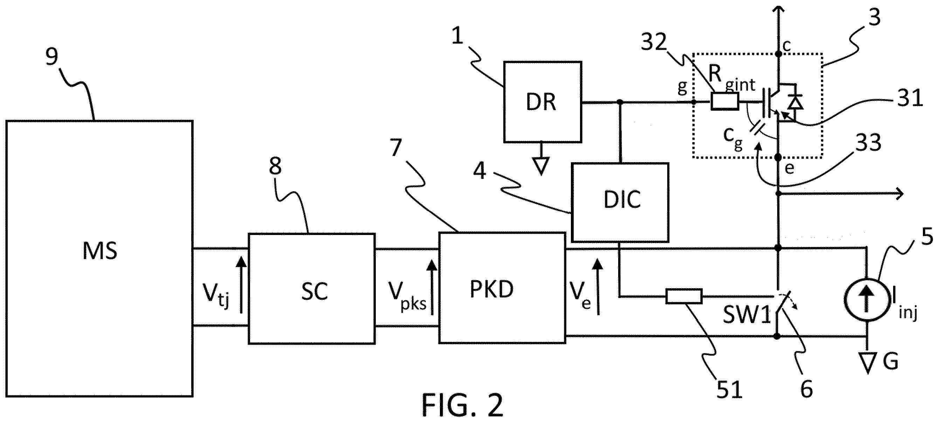

The device according to figure 2 comprises a current injector circuit 5 designed to inject current through the gate path of the power semiconductor switch 3. The gate path is the path comprising the junction emitter-gate in case of an IGBT, or gate-source in case of a MOSFET. Such gate path allows to monitor the value of the internal resistance Rgint of the semiconductor switch.

The device comprises further a digital injection control 4 configured to synchronize the current injection inside the PWM pulse at the output of the driver 1 of the power semiconductor switch 3 in order to inject the current Iᵢₙⱼ during a stable ON state period of the switch and for a precise duration. Such current injection provides at the poles of the current generator a voltage Ve dependent of the value or the resistor R_{gint}.

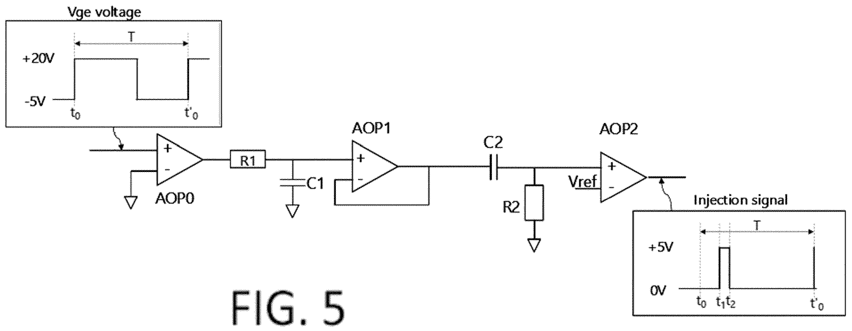

Figure 5 shows an example of implementation of the digital injection control circuit.

AOP0 is a comparator which translates the V_{ge} voltage, for a semiconductor switch 3 such as an IGBT, at the output of the gate driver into a logical signal, e.g. a signal comprised between 0V and +5V.

The components R1, C1 and AOP1 define the delay t1-t0 where t0 is the turning ON of the semiconductor switch 3.

The components C2, R2 and AOP2 define the delay t2-t1 defining the current Iᵢₙⱼ pulse duration and make such that a pulse is generated only at the rising front of V_{ge}. The reference voltage V_{ref} is typically generated with a simple resistor divider between the +5V and 0V rails.

Of course, other electronic circuits may be designed to perform such function.

Advantageously, the injections are made at an instant where the device is in ON-state and sufficiently after the turn ON to avoid any perturbation of the switching and the circuit does not require specific timing information and can be retrofitted to existing gate drivers.

The device comprises further a peak detector circuit 7 to record every Ve peak and generate through integration of Ve a nearly continuous signal Vₚₖₛ dependent of the junction temperature.

After the peak detector circuit, the device comprises a signal conditioning circuit 8 to convert the continuous signal Vₚₖₛ in the range of a measurement system 9.

The current pulses Iᵢₙⱼ injected in the gate path have durations calculated to limit contribution of the power semiconductor gate capacitor 33 value C_{g} to the emitter voltage peaks. The duration of the current injections within the ON PWM pulses is calculated to have the contribution of the gate capacitor value at least less than 5% of the amplitude of the voltage peak

The current injector 5 is typically a constant current source with small sense value. The current Iᵢₙⱼ is typically comprised between 20mA and 200mA in parallel. In idle mode, the switch is ON, and the current source is shorted. During the injection, a semiconductor switch SW1 6 which is a is turned OFF and the current source injects through the gate-emitter path of the device. The semiconductor switch 3 is typically a MOSFET which gate is connected to the digital injection control. A gate resistance 51 between 1 and 100 Ohms between the digital injection control and the gate of the switch SW1 may be used to slow-down its turn-off, reduce the di/dt in the gate loop and the related oscillations in voltage response.

Advantageously, the voltage response is insensitive to gate loop inductance.

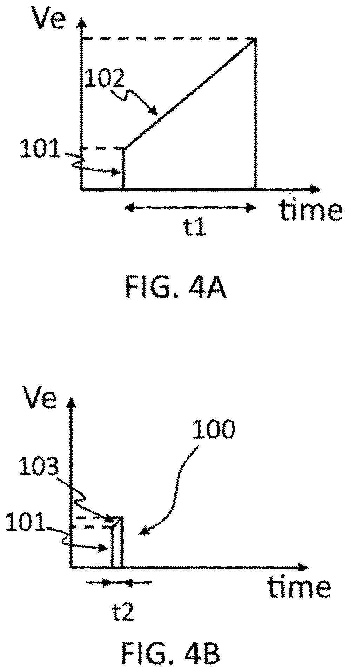

In figure 4A is shown the voltage Vₑ for a typical duration of 1 to 2 microseconds. Part 101 of the curve is the voltage rise when the current Iᵢₙⱼ starts to be injected due to the internal gate resistor Rgint and part 102 of the curve is the voltage rise due to the internal capacitor C_{g}. Figure 4B shows the curve for a short injection time of 20 to 200 nanoseconds which reduces the capacitive contribution 103. The main contribution to the Vₑ signal is then the gate resistor.

Advantageously, the variation of the capacitance with the operation contribution will have a limited impact on the temperature estimation. Moreover, the short time duration of injection will limit the perturbation on the gate voltage provided by the gate driver.

The error on R_{gint}, ΔR_{gint} can be estimated as a function of the time duration t according to the gate capacitance C_{g} and its variation ΔC_{g} using the following equation: $Δ {R}_{gint} = \frac{t ⋅ Δ {C}_{g}}{{{C}_{g}}^{2}}$

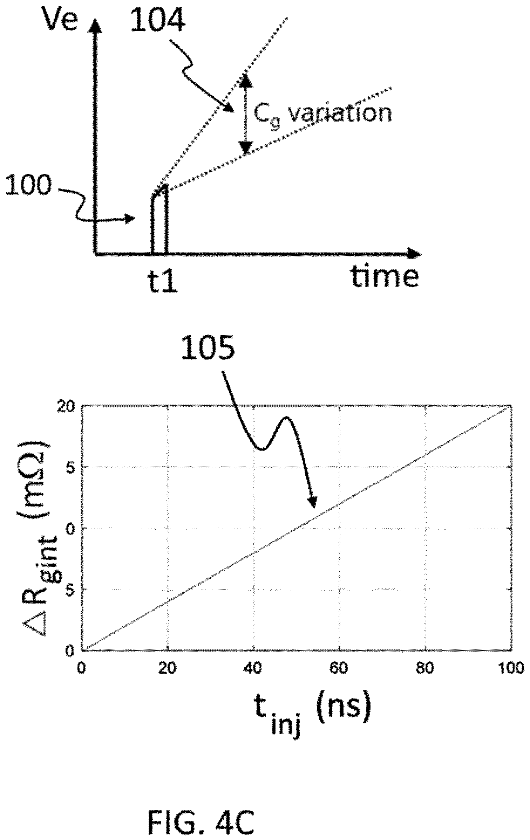

For example, for a typical gate capacitance of 50nF with a variation of ±1%, ΔR_{gint} as a function of time duration is shown in figure 4C. Thus, the maximum time duration can be estimated according to a specification in term of temperature error. For example, the typical gate resistor variation with temperature is about 0.1%/°C. Thus, for a gate resistor of 2Ω, the variation is about 0.002 Ω/°C. For a specification of ±10°C, ΔR_{gint} = ±20mΩ. This will give a maximum time duration of 100ns, as shown in figure 4C.

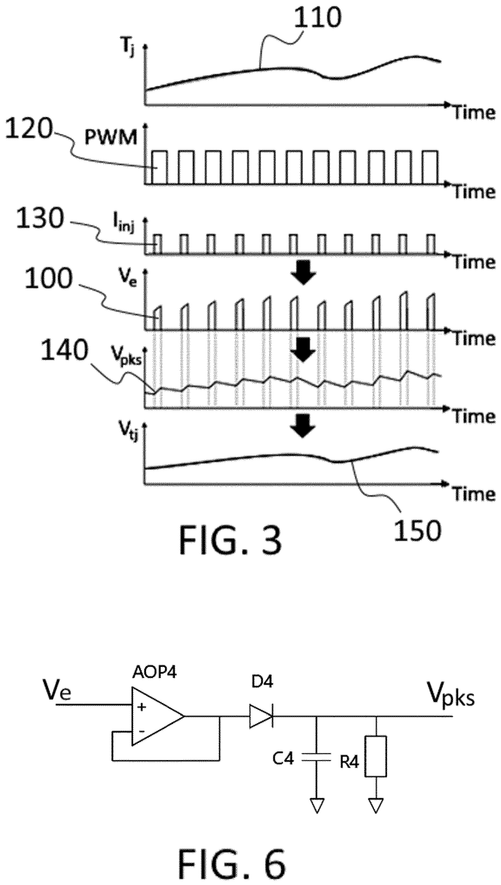

The signal during the current injection is recorded by the peak detector 7 of figure 2 which generates a continuous signal dependent of the junction temperature. An example of analog peak detector suited for this function is given in figure 6 where the voltage Ve is input in a voltage follower AOP4 then clamped by a diode D4 and capacitor C4 with a discharge resistor R4.

The value of the resistor R4, together with the value of C4, define the voltage discharge which is defined based on the cooling time constant of the die and the switching frequency. The minimum voltage ripple Vripple-min can be expressed as: ${V}_{ripple - min} = {δR}_{gint} ⋅ Δ {T}_{max} ⋅ {R}_{g 0} ⋅ {I}_{inj}$ (5)

With Δ*Tₘₐₓ* the maximum temperature decrease in a switching period based on the thermal characteristics of the power module. Note that leakage currents of passive and active components (i.e. operational amplifiers) also contribute to discharging the capacitor C4.

Alternatively, the circuit can be modified to remove or compensate the temperature drift of the threshold voltage of diode D4. Advantageously, both the rising and decreasing dynamics of the die temperature are reliably captured by the invention. The voltage Vₚₖₛ thus reflects the voltage Vₑ interpolated with a small ripple Vᵣᵢₚₚₗₑ and a voltage offset Vak which corresponds to the voltage drop across the diode D4. In the following equation Vᵣᵢₚₚₗₑ is neglected. ${V}_{pks} \approx \left({δR}_{gint}⋅{T}_{j}+1\right) {R}_{g 0} ⋅ {I}_{inj} - {V}_{ak}$

The curve obtained is shown in figure 3 where is shown a temperature variation curve 110, a PWM curve 120, the current pulses Iᵢₙⱼ 130 inside the ON pulses of the PWM curve. It can be seen that the resulting train of Vₑ peaks of every current injection follows the junction temperature of the power semiconductor 3 and where the peak detector 7 provides a continuous signal Vₚₖₛ 140 resulting of all Vₑ peaks Vₚₖₛ which is then dependent of the junction temperature transformed in the signal Vₜⱼ in the signal conditioning block 8 of figure 2.

The signal conditioning circuit converts Vpks into V_{Tj} shown in figure 3 within a range which can be easily compared with a threshold voltage value or measured by a basic measurement system such as an ADC.

The signal conditioning can typically include a low-pass filter and/or a gain and/or an offset implemented with low-cost operational amplifiers. ${V}_{Tj} \approx A ⋅ \left[\left({δR}_{gint}⋅{T}_{j}+1\right){R}_{g 0}⋅{I}_{inj}-{V}_{ak}\right] + B$ ${V}_{Tj} \approx \left(A⋅{δR}_{gint}⋅{T}_{j}⋅{R}_{g 0}⋅{I}_{inj}\right) - \left(A⋅{R}_{g 0}⋅{I}_{inj}-A⋅{V}_{ak}+B\right)$

Advantageously, VTj which depends on the junction temperature can be recorded continuously by any kind of measurement system without synchronisation and trigger, such as by a low frequency ADC. In addition, the measurement can be performed outside of the device and centralized e.g. in the mother board of the converter.

The temperature sensitive term of V_{Tj} is relatively robust to the individual power module reference and individual circuit as disclosed in the invention.

However, the offset term of V_{Tj} may vary for each individual power module reference and individual circuit. A calibration is thus typically performed afterward, at a known temperature, to tune this offset term.

In a preferred implementation of over-temperature detection, the analogue output is directly compared with a threshold value which value can be defined after a calibration at a known temperature.

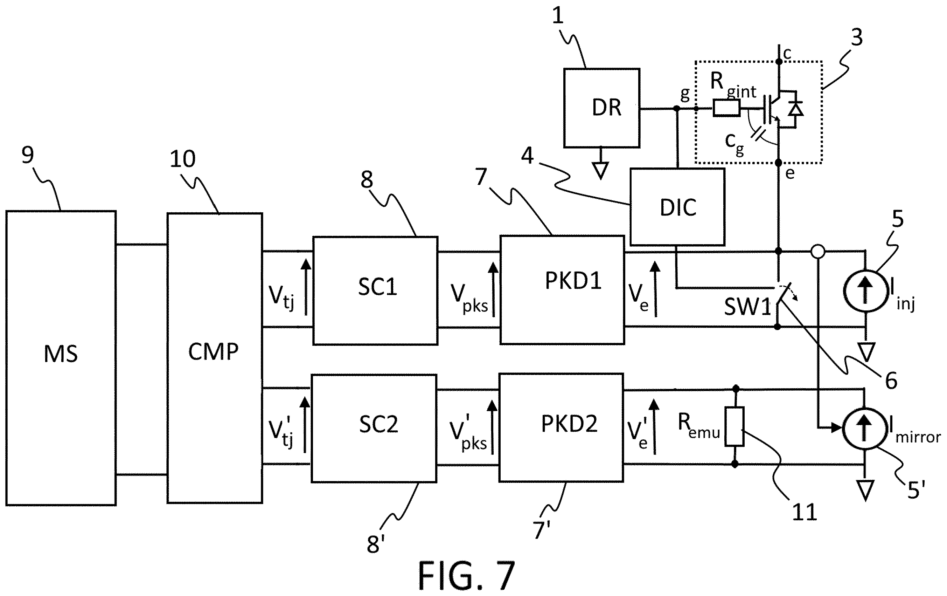

In an alternative mode of implementation as shown in figure 7, a threshold value is generated with an analogue circuit which implements a current mirror 5', at least a resistor Rₑₘᵤ 11 mimicking the internal gate resistor and a second peak detector PKD2 7'. The resistor circuit can also include a series capacitance and inductance to mimic the gate loop impedance. The resistance can be variable, i.e. a potentiometer, to adjust the over-temperature threshold value (e.g. 125°C or 150°C).

The rest of the circuit comprises a second signal conditioner SC2 8' and a comparator 10 receiving the Vₜⱼ and Vₜⱼ' signals from the measurement circuit 5, 7, 8 and the threshold value generating circuit 5', 7', 8'.

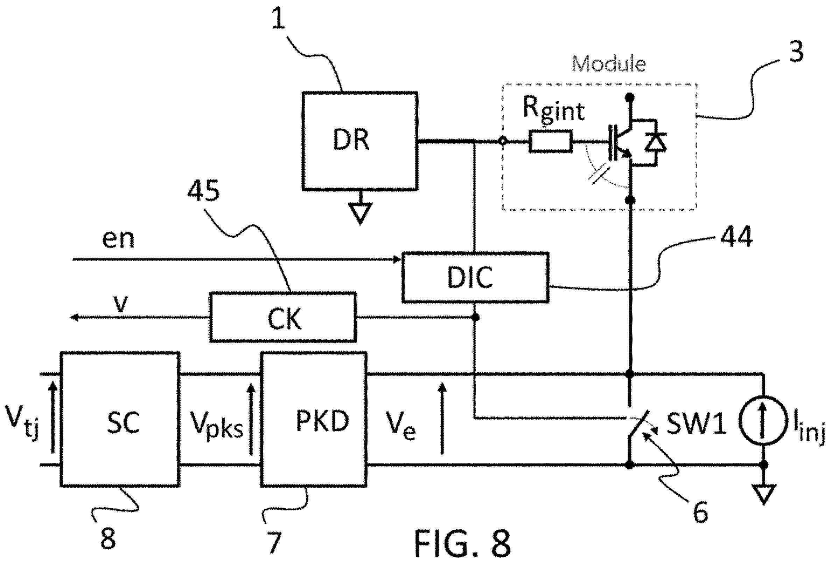

Figure 8 shows alternative modes of implementation of a R_{gint} measurement circuit of the present disclosure. In this circuit, the digital injection control 44 includes an enable input "en" and the output of the digital injection control is not only connected to the injection switch SW1 but also connected to a verification circuit CK 45. The verification circuit is configured to output a logical 1 if the injection may be performed, that is during a positive pulse of the PWM and outputs a logical 0 if the injection could not be performed. This may happen when the on-time of the PWM pulse is shorter than the delay set by the digital injection control circuit 44 according to figure 5, which may occur in some applications for some specific operating points where the duty-cycle may be close to 100% or 0%.

Advantageously, with this implementation mode, the absence of measurement cannot be interpreted as a low temperature.

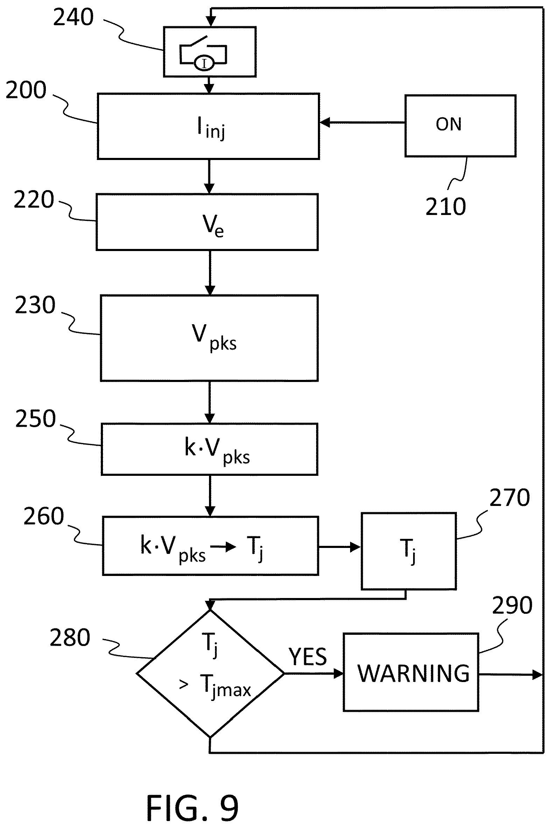

Figure 9 describes features of a method for measuring a junction temperature of a power semiconductor 3 through the measurement of the gate resistance 32 of such power semiconductor 3 comprising injecting 200 current pulses linj in the gate path of said power semiconductor 3 through the emitter of said power semiconductor, said current pulses being synchronized 210 with a stabilized part of ON states of the power semiconductor 3 during PWM pulses in the power semiconductor.

The method comprises detecting 220 emitter voltage peaks Vₑ at terminals of a current generator circuit 5 injecting said current pulses linj and integrating at 230 said peaks Vₑ to generate a continuous signal Vₚₖₛ dependent of the junction temperature Tj.

In the example, said current pulses Iᵢₙⱼ are generated through unshorting 240 the current generator 5 connected between a digital ground G and an emitter e of said power semiconductor 3 for the duration of said current pulses Iᵢₙⱼ.

The continuous signal Vₚₖₛ dependent of the junction temperature is adapted 250 in a signal conditioning circuit 8 to correspond to a range of 3V to 5V of a measurement system 9.

The signal Vₚₖₛ is converted 260 into a temperature θj in said measurement system and said temperature θj is displayed 270 and/or compared 280 to a maximum acceptable temperature θjmax to provide a warning 290 when said temperature θj is above said maximum acceptable temperature θjmax.

### Industrial Applicability

The technical solutions presented here can be used to provide junction temperature measurements to protect semiconductor switches of power converters or electric motor control systems for electric vehicle motors.

## Claims

1. - Device for measuring a junction temperature of a power semiconductor (3) using the resistance Rgint (32) of said semiconductor (3) comprising at least:
a current injector circuit (5) injecting current pulses Iᵢₙⱼ in the gate path of said power semiconductor (3) through the emitter of said power semiconductor, said current injector circuit (5) being driven by a digital injection control circuit (4, 6) to synchronize said current pulses within a stabilized part of ON states of the power semiconductor driver (1) PWM signal driving said power semiconductor (3),
a peak detector circuit (7) to record emitter voltage peaks Vₑ at the terminals of the current injector circuit and generate a continuous signal Vₚₖₛ dependent of the junction temperature Tj through integration of said voltage peaks,
a signal conditioning circuit (8) to adapt the continuous signal Vₚₖₛ dependent of the junction temperature into a range of 3V to 5V of a measurement system (9).

2. - Device according to claim 1, wherein said current pulses injected in said gate path have durations calculated to limit contribution of the power semiconductor gate capacitor C_{g} (33) value to the emitter voltage peaks.

3. - Device according to claim 2, wherein said current pulses injected in said gate path have a typical duration of 20 ns to 200 ns.

4. - Device according to claim 1, 2 or 3 wherein the injection of said current pulses starts between 20% and 50 % of the ON state of the power semiconductor.

5. - Device according to any one of the preceding claims, wherein the current injector circuit is a current source and wherein the current pulses Iᵢₙⱼ have a typical amplitude of 20 mA to 200 mA.

6. - Device according to any one of the preceding claims, wherein the digital injection control circuit comprises a switch SW1 (6) shorting said current source when said current pulses are not injected.

7. - Device according to claim 6, comprising a gate resistor (51) on the bypass switch SW1 (6).

8. - Device according to claim 7, wherein said gate resistor (51) value is between 1 Ohm and 100 Ohm.

9. - Device according to any one of the preceding claims, wherein the current pulse Iᵢₙⱼ is synchronized through the Vge gate signal generated by the gate driver (1).

10. - Device according to any one of the preceding claims, wherein the current pulse Iᵢₙⱼ is started between 1µs and 10µs after a turn-ON order of the power semiconductor (3) from the driver (1).

11. - Converter comprising at least one power module equipped with at least one power semiconductor equipped with a device according to any one of claims 1 to 10.

12. - Method for measuring a junction temperature of a power semiconductor (3) through the measurement of the gate resistance (32) of such power semiconductor (3) comprising injecting (200) current pulses Iᵢₙⱼ in the gate path of said power semiconductor (3) through the emitter of said power semiconductor, said current pulses being synchronized (210) with a stabilized part of ON states of the power semiconductor (3) and detecting (220) emitter voltage peaks Vₑ at terminals of a current generator circuit (5) injecting said current pulses and integrating (230) said peaks Vₑ to generate a continuous signal Vₚₖₛ dependent of the junction temperature Tj,

13. - Method according to claim 12, comprising providing said current pulses Iᵢₙⱼ through unshorting (240) a current generator (5) connected between the gate driver ground G and an emitter (e) of said power semiconductor (3) for the duration of said current pulses Iᵢₙⱼ.

14. - Method according to claim 12 or 13, wherein the continuous signal Vₚₖₛ dependent of the junction temperature is adapted (250) to correspond to a range of 3V to 5V of a measurement system (9).

15. - Method according to claim 14, wherein said signal Vₚₖₛ is converted (260) into a temperature θj in said measurement system and said temperature θj is displayed (270) and/or compared (280) to a maximum acceptable temperature θjmax to provide a warning (290) when said temperature θj is above said maximum acceptable temperature θjmax.

## Patentansprüche

1. Vorrichtung zum Messen einer Sperrschichttemperatur eines Leistungshalbleiters (3) unter Verwendung des Widerstands Rgint (32) des Halbleiters (3), wenigstens umfassend:
eine Strom-Eingabeschaltung (5), welche Strompulse Iᵢₙⱼ in den Gate-Pfad des Leistungshalbleiters (3) durch den Emitter des Leistungshalbleiters eingibt, wobei die Strom-Eingabeschaltung (5) durch eine digitale Eingabe-Steuerschaltung (4, 6) getrieben ist, um die Strompulse innerhalb eines stabilisierten Teils von AN-Zuständen des Leistungshalbleiter-Treiber (1)-PWM-Signals zu synchronisieren, welches den Leistungshalbleiter (3) treibt, eine Spitzen-Detektorschaltung (7) zum Aufzeichnen von Emitter-Spannungsspitzen Vₑ an den Anschlüssen der Strom-Eingabeschaltung und Erzeugen eines kontinuierlichen Signals Vₚₖₛ, welches von der Sperrschichttemperatur Tj abhängt, durch Integration der Spannungsspitzen,
eine Signal-Konditionierungsschaltung (8) zum Anpassen des kontinuierlichen Signals Vₚₖₛ, welches von der Sperrschichttemperatur abhängt, in einen Bereich von 3V bis 5V eines Messsystems (9).

2. Vorrichtung nach Anspruch 1, wobei die Strompulse, welche in den Gate-Pfad eingegeben werden, Zeitdauern aufweisen, welche berechnet werden, um einen Beitrag des Leistungshalbleiter-Gatekondensator C_{G} (33)-Werts zu den Emitter-Spannungsspitzen zu begrenzen.

3. Vorrichtung nach Anspruch 2, wobei die Strompulse, welche in den Gate-Pfad eingegeben werden, eine typische Zeitdauer von 20 ns bis 200 ns aufweisen.

4. Vorrichtung nach Anspruch 1, 2 oder 3, wobei das Eingeben der Strompulse zwischen 20% und 50% des AN-Zustands des Leistungshalbleiters startet.

5. Vorrichtung nach einem der vorhergehenden Ansprüche, wobei die Strom-Eingabeschaltung eine Stromquelle ist, und wobei die Strompulse Iᵢₙⱼ eine typische Amplitude von 20 mA bis 200 mA aufweisen.

6. Vorrichtung nach einem der vorhergehenden Ansprüche, wobei die digitale Eingabe-Steuerschaltung einen Schalter SW1 (6) umfasst, welcher die Stromquelle kurzschließt, wenn die Strompulse nicht eingegeben werden.

7. Vorrichtung nach Anspruch 6, umfassend einen Gate-Widerstand (51) an dem Bypass-Schalter SW1 (6).

8. Vorrichtung nach Anspruch 7, wobei der Gate-Widerstand (51)-Wert zwischen 1 Ohm und 100 Ohm beträgt.

9. Vorrichtung nach einem der vorhergehenden Ansprüche, wobei der Strompuls Iᵢₙⱼ durch das Vge-Gate-Signal synchronisiert wird, welches durch den Gate-Treiber (1) erzeugt wird.

10. Vorrichtung nach einem der vorhergehenden Ansprüche, wobei der Strompuls Iᵢₙⱼ zwischen 1 µs und 10 µs nach einem AN-Schaltbefehl des Leistungshalbleiters (3) von dem Treiber (1) gestartet wird.

11. Wandler, umfassend wenigstens ein Leistungsmodul, welches mit wenigstens einem Leistungshalbleiter ausgerüstet ist, welcher mit einer Vorrichtung nach einem der Ansprüche 1 bis 10 ausgerüstet ist.

12. Verfahren zum Messen einer Sperrschichttemperatur eines Leistungshalbleiters (3) durch die Messung des Gate-Widerstands (32) eines solchen Leistungshalbleiters (3), umfassend ein Eingeben (200) von Strompulsen Iᵢₙⱼ in den Gate-Pfad des Leistungshalbleiters (3) durch den Emitter des Leistungshalbleiters, wobei die Strompulse mit einem stabilisierten Teil von AN-Zuständen des Leistungshalbleiters (3) synchronisiert (210) werden, und Detektieren (220) von Emitter-Spannungsspitzen Vₑ an Anschlüssen einer Strom-Erzeugungsschaltung (5), welche die Strompulse eingibt, und Integrieren (230) der Spitzen Vₑ zum Erzeugen eines kontinuierlichen Signals Vₚₖₛ, welches von der Sperrschichttemperatur Tj abhängt.

13. Verfahren nach Anspruch 12, umfassend ein Bereitstellen der Strompulse Iᵢₙⱼ durch ein Aufheben eines Kurzschlusses (240) eines Stromerzeugers (5), welcher zwischen der Gate-Treiber-Erdung G und einem Emitter (e) des Leistungshalbleiters (3) angeordnet ist, für die Zeitdauer der Strompulse Iᵢₙⱼ.

14. Verfahren nach Anspruch 12 oder 13, wobei das kontinuierliche Signal Vₚₖₛ, welches von der Sperrschichttemperatur abhängt, angepasst (250) wird, um einem Bereich von 3V bis 5V eines Messsystems (9) zu entsprechen.

15. Verfahren nach Anspruch 14, wobei das Signal Vₚₖₛ in eine Temperatur θj in dem Messsystem konvertiert (260) wird und die Temperatur θj angezeigt (270) und/oder mit einer maximal akzeptablen Temperatur θjmax verglichen (280) wird, um eine Warnung (290) bereitzustellen, wenn die Temperatur θj oberhalb der maximal akzeptablen Temperatur θjmax ist.

## Revendications

1. Dispositif de mesure d'une température de jonction d'un semi-conducteur de puissance (3) à l'aide de la résistance Rgint (32) dudit semi-conducteur (3) comprenant au moins :
un circuit injecteur de courant (5) injectant des impulsions de courant Iᵢₙⱼ dans le chemin de grille dudit semi-conducteur de puissance (3) à travers l'émetteur dudit semi-conducteur de puissance, ledit circuit injecteur de courant (5) étant piloté par un circuit de commande d'injection numérique (4, 6) pour synchroniser lesdites impulsions de courant dans une partie stabilisée d'états passants du signal PWM d'un pilote (1) de semi-conducteur de puissance pilotant ledit semi-conducteur de puissance (3),
un circuit détecteur de pics (7) pour enregistrer des pics de tension d'émetteur Vₑ aux bornes du circuit injecteur de courant et générer un signal continu Vₚₖₛ dépendant de la température de jonction Tj par intégration desdits pics de tension,
un circuit de conditionnement de signal (8) pour adapter le signal continu Vₚₖₛ dépendant de la température de jonction dans une plage de 3V à 5V d'un système de mesure (9).

2. Dispositif selon la revendication 1, dans lequel lesdites impulsions de courant injectées dans ledit chemin de grille ont des durées calculées pour limiter une contribution de la valeur d'un condensateur C_{g} (33) de grille de semi-conducteur de puissance aux pics de tension d'émetteur.

3. Dispositif selon la revendication 2, dans lequel lesdites impulsions de courant injectées dans ledit chemin de grille ont une durée typique de 20 ns à 200 ns.

4. Dispositif selon la revendication 1, 2 ou 3 dans lequel l'injection desdites impulsions de courant commence entre 20 % et 50 % de l'état passant du semi-conducteur de puissance.

5. Dispositif selon l'une quelconque des revendications précédentes, dans lequel le circuit injecteur de courant est une source de courant et dans lequel les impulsions de courant Iᵢₙⱼ ont une amplitude typique de 20 mA à 200 mA.

6. Dispositif selon l'une quelconque des revendications précédentes, dans lequel le circuit de commande d'injection numérique comprend un commutateur SW1 (6) courtcircuitant ladite source de courant lorsque lesdites impulsions de courant ne sont pas injectées.

7. Dispositif selon la revendication 6, comprenant une résistance de grille (51) sur le commutateur de dérivation SW1 (6).

8. Dispositif selon la revendication 7, dans lequel ladite valeur de la résistance de grille (51) est comprise entre 1 ohm et 100 ohms.

9. Dispositif selon l'une quelconque des revendications précédentes, dans lequel l'impulsion de courant Iᵢₙⱼ est synchronisée par le biais du signal de grille Vge généré par le dispositif pilote de grille (1).

10. Dispositif selon l'une quelconque des revendications précédentes, dans lequel l'impulsion de courant Iᵢₙⱼ est démarrée entre 1 µs et 10 µs après un ordre d'activation du semi-conducteur de puissance (3) provenant du pilote (1).

11. Convertisseur comprenant au moins un module de puissance équipé d'au moins un semi-conducteur de puissance équipé d'un dispositif selon l'une quelconque des revendications 1 à 10.

12. Procédé de mesure d'une température de jonction d'un semi-conducteur de puissance (3) par la mesure de la résistance de grille (32) d'un tel semi-conducteur de puissance (3) comprenant l'injection (200) d'impulsions de courant Iᵢₙⱼ dans le chemin de grille dudit semi-conducteur de puissance (3) à travers l'émetteur dudit semi-conducteur de puissance, lesdites impulsions de courant étant synchronisées (210) avec une partie stabilisée d'états passants du semi-conducteur de puissance (3) et la détection (220) de pics de tension d'émetteur Vₑ à des bornes d'un circuit générateur de courant (5) injectant lesdites impulsions de courant et l'intégration (230) desdits pics Vₑ pour générer un signal continu Vₚₖₛ dépendant de la température de jonction Tj.

13. Procédé selon la revendication 12, comprenant la fourniture desdites impulsions de courant Iᵢₙⱼ par suppression de court-circuit (240) d'un générateur de courant (5) connecté entre la masse G d'un pilote de grille et un émetteur (e) dudit semi-conducteur de puissance (3) pendant la durée desdites impulsions de courant Iᵢₙⱼ.

14. Procédé selon la revendication 12 ou 13, dans lequel le signal continu Vₚₖₛ dépendant de la température de jonction est adapté (250) pour correspondre à une plage de 3V à 5V d'un système de mesure (9).

15. Procédé selon la revendication 14, dans lequel ledit signal Vₚₖₛ est converti (260) en une température θj dans ledit système de mesure et ladite température θj est affichée (270) et/ou comparée (280) à une température acceptable maximale θjmax pour fournir un avertissement (290) lorsque ladite température θj est supérieure à ladite température acceptable maximale θjmax.
